(19)

Europäisches
Patentamt
European
Patent Office
Office européen
des brevets

(11) **EP 4 340 218 A1**

(12) **EUROPEAN PATENT APPLICATION**

(43) Date of publication:
    **20.03.2024 Bulletin 2024/12**

(51) International Patent Classification (IPC):
    **H03C 3/09** *(2006.01)*        **H03C 5/00** *(2006.01)*

(21) Application number: **23151958.8**

(22) Date of filing: **17.01.2023**

(52) Cooperative Patent Classification (CPC):
    **H03C 5/00; H03C 3/0941**

(84) Designated Contracting States:
    **AL AT BE BG CH CY CZ DE DK EE ES FI FR GB
    GR HR HU IE IS IT LI LT LU LV MC ME MK MT NL
    NO PL PT RO RS SE SI SK SM TR**
    Designated Extension States:
    **BA**
    Designated Validation States:
    **KH MA MD TN**

(30) Priority: **13.09.2022 IN 202211052248**

• **LESELLIER, Amandine**
  **14906 Caen (FR)**
• **AHIRWAR, Vijay**
  **5656AG Eindhoven (NL)**

(74) Representative: **Krott, Michel**
    **NXP Semiconductors**
    **Intellectual Property Group**
    **High Tech Campus 60**
    **5656 AG Eindhoven (NL)**

(71) Applicant: **NXP B.V.**
    **5656 AG Eindhoven (NL)**

(72) Inventors:
    • **JAMIN, Olivier Jérôme Célestin**
      **14906 Caen (FR)**

Remarks:
    Amended claims in accordance with Rule 137(2)
    EPC.

(54)    **CIRCUIT FOR POLAR TRANSMITTER AND METHOD OF OPERATING A POLAR TRANSMITTER**

(57)    There is described a circuit (101, 201, 501) for a polar transmitter, the circuit comprising a frequency modulation path (110, 210, 510) coupled to receive a frequency modulation signal (FM(nT)) and configured to generate a frequency modulated signal (LO(t)) based on the frequency modulation signal; a non-uniform clock time error calculation unit (120, 220, 320, 520) configured to determine a delay value (delay(nT)) based on the frequency modulation signal; an amplitude modulation path (130, 230, 530) coupled to receive an amplitude modulation signal (AM(nT)) and comprising a non-uniform clock correction unit (134, 234, 434, 536) coupled to the non-uniform clock time error calculation unit and configured to generate a modified amplitude modulation signal (AM _mod(nT), AM src_mod(nT)) based on the amplitude modulation signal and the delay value; and a transmitter (140, 241) coupled to the frequency modulation path and the amplitude modulation path, wherein the transmitter is configured to generate a modulated signal based on the frequency modulated signal and the modified amplitude modulation signal. Furthermore, a method of operating a polar transmitter is described.

Fig. 1

**EP 4 340 218 A1**

**Description**

TECHNICAL FIELD

The present disclosure relates to the field of RF communications. More specifically, the present disclosure relates to a circuit for a polar transmitter and a method of operating a polar transmitter.

ART BACKGROUND

Low-power state-of-the-art RF transceivers may use a two-point-PLL modulator concept in order to directly apply frequency (or phase) modulation (FM/PM) in the PLL, and thereby avoid a more power-hungry and bigger IQ transmitter. This is working fine when only FM/PM has to be transmitted. If the modulation also includes amplitude modulation (AM) (as for instance BT EDR 2Mbps and BT EDR 3Mbps), this two-point-PLL-modulation transmitter concept is still an appropriate choice due to its low current consumption but requires an additional path for the amplitude modulation. However, the combination of a two-point-modulation-PLL path and an amplitude modulation path have some limitations. One limitation is a static delay mismatch between the AM path and the FM/PM path, which translates into degraded RF performance (in-band emissions, Differential Error Vector Magnitude (D-EVM), etc.) and thus necessitates a static delay equalization. While this static issue can be solved by inserting adjustable delay blocks in the AM and FM paths, other problems remain. In particular, if the AM path is clocked with the LO signal generated by the FM path, or a frequency-divided version of the LO signal, an FM-to-AM distortion arises due to the fact that the LO signal carries a frequency modulation (or phase modulation) in all two-point-PLL-modulators. Seen from another angle, clocking the AM path with the LO signal (or a frequency-divided version of the LO signal) introduces a variable time delay between the AM path and the PM/FM path which leads to signal quality degradation. In BT EDR 2Mbps and 3Mbps, this degradation impacts In-Band Emissions (IBE) and Differential Error Vector Magnitude (D-EVM), which might even prevent meeting the Bluetooth standard requirement.

There may thus be a need for a way of overcoming the above problems, preferably with a low-area and low-power hardware solution.

SUMMARY

This need may be met by the subject matter according to the independent claims. Advantageous embodiments of the present disclosure are set forth in the dependent claims.

According to a first aspect, there is provided a circuit for a polar transmitter, the circuit comprising (a) a frequency modulation path coupled to receive a frequency modulation signal and configured to generate a frequency modulated signal based on the frequency modulation signal, (b) a non-uniform clock time error calculation unit configured to determine a delay value based on the frequency modulation signal (c) an amplitude modulation path coupled to receive an amplitude modulation signal and comprising a non-uniform clock correction unit coupled to the non-uniform clock time error calculation unit and configured to generate a modified amplitude modulation signal based on the amplitude modulation signal and the delay value, and (d) a transmitter coupled to the frequency modulation path and the amplitude modulation path, wherein the transmitter is configured to generate a modulated signal based on the frequency modulated signal and the modified amplitude modulation signal.

This aspect is based on the idea that a delay value is determined based on the frequency modulation signal and used to generate a modified amplitude modulation signal. In this way, signal quality degradation caused by a variable time delay between the amplitude modulation (AM) path and the frequency modulation (FM) path can be prevented. The delay value may be positive or negative depending on whether the frequency modulation causes an increase or a decrease in frequency.

In the present context, the term "frequency modulation signal" may denote a signal indicating an amount of frequency modulation to be applied at a given time. The amount may in particular indicate an absolute or relative deviation from a reference frequency. Hereinafter, the frequency modulation signal will also be referred to as FM(nT).

In the present context, the term "amplitude modulation signal" may denote a signal indicating an amount of amplitude modulation to be applied at a given time. The amount may in particular indicate an amplitude scaling or gain factor. Hereinafter, the amplitude modulation signal will also be referred to as AM(nT).

According to an embodiment, the transmitter is configured to derive a transmitter clock from the frequency modulated signal.

In other words, the transmitter uses the frequency modulated signal to generate a transmitter clock which may e.g. be utilized to sample the modified amplitude modulation signal when generating the modulated signal.

According to a further embodiment, the transmitter is configured to derive the transmitter clock from the frequency modulated signal by dividing a frequency of the frequency modulated signal by a predetermined number, in particular a predetermined integer number or a predetermined fractional number.

According to a further embodiment, the non-uniform clock time error calculation unit is configured to determine the delay value by calculating an instantaneous cumulated time error of the transmitter clock relative to a reference clock used to generate the frequency modulation signal and the amplitude modulation signal.

In other words, the delay value is calculated by cumulating the deviation between the transmitter clock (which may be derived from the frequency modulated signal) and the reference clock.

According to a further embodiment, calculating the instantaneous cumulated time error comprises integrating the frequency modulation signal.

According to a further embodiment, the non-uniform clock correction unit comprises a fractional delay filter.

According to a further embodiment, the non-uniform clock correction unit comprises a fractional delay filter that is configured as a Farrow structure.

According to a further embodiment, the non-uniform clock correction unit comprises a sampling rate converter configured to generate an up-sampled amplitude modulation signal. Furthermore, the non-uniform clock correction unit is configured to generate the modified amplitude modulation signal based on the up-sampled amplitude modulation signal and the delay value.

In other words, a sampling rate converter is used to convert the amplitude modulation signal from a sampling frequency corresponding to the reference clock to a higher sampling frequency.

According to a further embodiment, the sampling rate converter is configured to apply a sampling rate which is based on the frequency of the frequency modulated signal.

In other words, the sampling frequency of the up-sampled amplitude modulation signal is based on the frequency modulated signal and as such varies with the frequency of the frequency modulated signal, which is always significantly higher than the reference clock. Thereby, AM images or replicas is attenuated.

According to a further embodiment, the sampling rate converter comprises a Farrow sampling rate converter or a modified Farrow sampling rate converter.

According to a further embodiment, the transmitter comprises a digital RF power amplifier configured to provide an output signal with an amplitude that depends on the modified amplitude modulation signal.

In other words, the amplitude of the modulated signal is determined by the amplitude of the modulation signal. Hence, if the modulation signal is maximum, the modulated signal will have maximum amplitude, and if the modulation signal is minimum, the modulated signal will have minimum amplitude.

According to a further embodiment, the frequency modulation path comprises a 2-point modulation PLL circuit configured to generate the frequency modulated signal.

According to a second aspect, there is provided a method of operating a polar transmitter, the method comprising (a) receiving a frequency modulation signal, (b) generating a frequency modulated signal based on the frequency modulation signal, (c) determining a delay value based on the frequency modulation signal, (d) receiving an amplitude modulation signal, (e) generating a modified amplitude modulation signal based on the amplitude modulation signal and the delay value, and (f) generating a modulated signal based on the frequency modulated signal and the modified amplitude modulation signal.

This aspect is essentially based on the same idea as the first aspect discussed above and provides the same features and advantages in terms of a method.

According to a further embodiment, the method further comprises (a) deriving a transmitter clock from the frequency modulated signal, and (b) utilizing the transmitter clock to sample the modified amplitude modulation signal when generating the modulated signal.

As explained above, the frequency modulated signal is thus used to generate a transmitter clock which may e.g. be utilized to sample the modified amplitude modulation signal when generating the modulated signal.

According to a further embodiment, determining the delay value comprises calculating an instantaneous cumulated time error of the transmitter clock relative to a reference clock used to generate the frequency modulation signal and the amplitude modulation signal.

As explained above, the delay value is thus calculated by cumulating the deviation between the transmitter clock (which may be derived from the frequency modulated signal) and the reference clock.

According to a further embodiment, calculating the instantaneous cumulated time error comprises integrating the frequency modulation signal.

According to a further embodiment, generating the modified amplitude modulation signal utilizes a fractional delay filter, in particular a fractional delay filter that is configured as a Farrow structure.

According to a further embodiment, the method further comprises (a) generating an up-sampled amplitude modulation signal, and (b) generating the modified amplitude modulation signal based on the up-sampled amplitude modulation signal and the delay value.

In other words, the amplitude modulation signal is converted from a sampling frequency corresponding to the reference clock to a higher sampling frequency.

According to a further embodiment, the method further comprises generating the up-sampled amplitude modulation signal by utilizing a sample rate converter configured to apply a sampling rate which is based on the frequency of the frequency modulated signal, wherein the sampling rate converter in particular comprises a Farrow sampling rate converter or a modified Farrow sampling rate converter.

In other words, the sampling frequency of the up-sampled amplitude modulation signal is based on the frequency modulated signal and as such varies with the frequency of the frequency modulated signal, which is always significantly higher than the reference clock. Thereby, AM images or replicas are attenuated.

It should be noted that exemplary embodiments have been described with reference to different subject matters. In particular, some embodiments have been described with reference to method type claims whereas other embodiments have been described with reference to apparatus type claims. However, a person skilled in the art will gather from the above and the following description that, unless otherwise indicated, in addition to any combination of features belonging to one type of subject matter also any combination of features relating to different subject matters, in particular a combination of features of the method type claims and features of the apparatus type claims, is also disclosed with this document.

The aspects defined above and further aspects of the present disclosure will be apparent from the examples of embodiment to be described hereinafter and are explained with reference to the examples of embodiment. Aspects of the present disclosure will be described in more detail hereinafter with reference to examples of embodiment to which the present disclosure is, however, not limited.

BRIEF DESCRIPTION OF THE DRAWINGS

Figure 1 shows a circuit according to an exemplary embodiment.
Figure 2 shows a circuit according to a further exemplary embodiment.
Figure 3 shows a circuit diagram of a non-uniform clock time error calculation unit according to an exemplary embodiment.
Figure 4 shows a circuit diagram of a non-uniform clock correction unit according to an exemplary embodiment.
Figure 5 shows a circuit according to a further exemplary embodiment.
Figure 6 shows a circuit diagram of a non-uniform clock correction unit according to a further exemplary embodiment.
Figure 7 shows a circuit diagram of a delay line according to an exemplary embodiment.
Figure 8 shows a flowchart of a method according to an exemplary embodiment.

DETAILED DESCRIPTION

The illustration in the drawing is schematic. It is noted that in different figures, similar or identical elements are provided with the same reference signs or with reference signs, which differ only within the first digit.

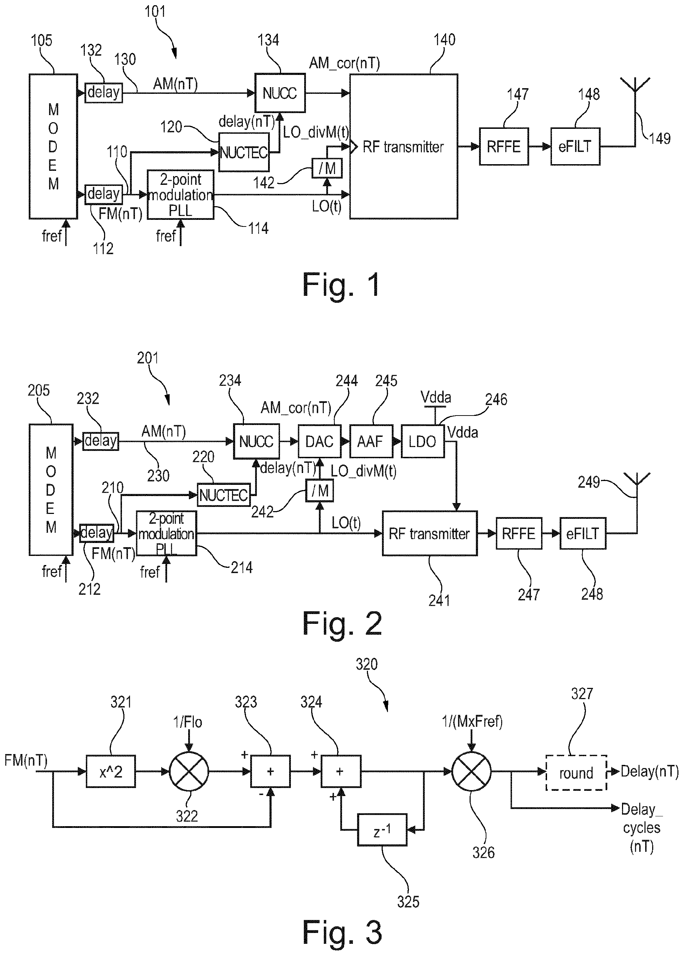

Figure 1 shows a circuit 101 for a polar transmitter according to an exemplary embodiment. The circuit comprises a frequency modulation path (or FM path) 110, a non-uniform clock time error calculation unit 120 (also referred to as NUCTEC unit 120), an amplitude modulation path (or AM path) 130, and an RF transmitter 140.

The FM path 110 is coupled to receive a frequency modulation signal FM(nT) from a modem 105 via a static delay 112. The FM path 110 comprises a 2-point modulation PLL circuit 114 configured to generate a frequency modulated signal LO(t) based on the frequency modulation signal FM(nT).

The NUCTEC unit 120 is coupled to received the frequency modulation signal FM(nT) and configured to determine a delay value delay(nT) based on FM(nT).

The AM path 130 is coupled to receive an amplitude modulation signal AM(nT) from the modem 105 via a static delay 132. The AM path 130 comprises a non-uniform clock correction unit 134 (also referred to as NUCC unit 134) coupled to receive the delay value delay(nT) from the NUCTEC unit 120. Furthermore, the NUCC unit 134 is configured to generate a modified (or corrected) amplitude modulation signal AM cor(nT) based on the amplitude modulation signal AM(nT) and the delay value delay(nT).

The transmitter 140 is coupled to both the FM path 110 and the AM path 130. Thereby, the transmitter 140 receives the frequency modulated signal LO(t) and the modified amplitude modulation signal AM_cor(nT). Furthermore, the transmitter 140 is configured to generate a modulated signal based on the frequency modulated signal LO(t) and the modified amplitude modulation signal AM_cor(nT). In doing so, the transmitter may derive a transmitter clock (for sampling AM_cor(nT)) from the frequency modulated signal LO(t). In that regard, the frequency modulated signal LO(t) may be passed through a dividing unit 142 to generate a corresponding divided frequency modulated signal LO_divM(t) which is supplied to the transmitter 140. The dividing unit 142 may be configured to apply division by M, where M may be an integer number or a fractional number. The output from the transmitter 140, i.e., a signal involving both frequency modulation and amplitude modulation in accordance with FM(nT) and AM(nT), is passed through RF front end 147 and external filter 148 to antenna 149.

Returning to NUCTEC unit 120, this unit is configured to determine the delay value delay(nT) by calculating an instantaneous cumulated time error of the transmitter clock relative to a reference clock used to generate the frequency modulation signal and the amplitude modulation signal. Thus, the delay value delay(nT) represents the instantaneous deviation between the transmitter clock (which is used to sample the modified amplitude modulation signal AM cor(nT) at the transmitter 140) and the clock that was used to generate AM_(nT). By applying the delay value dealy(nT) in the NUCC unit 134 and thereby modifying the amplitude modulation signal correspondingly, it becomes possible to correctly sample the modified amplitude modulation signal AM_cor(nT) correctly at the transmitter 140 when using a sampling clock (transmitter clock) that is derived from the frequency modulated signal LO(t).

Without the NUCC unit 134, the RF transmitter 140 would simply amplify the frequency modulated signal LO(t) with an amplitude scaling proportional (in case of a linear power amplifier) to the amplitude modulation signal AM(nT) from the modem 105, i.e., RF(t) = LO(t) * AM(t). Since the digital amplitude modulation signal AM(nT) is somehow clocked by the LO-divided-by M clock LO_divM(t) inside the RF transmitter 140, the frequency-modulated clock introduces an error to the AM(nT) signal itself, thereby leading to a time-variable delay between the PM(nT) and AM(nT) signals. The non-uniform clock time error calculation unit 120 and the non-uniform clock correction unit 134 are solving this issue.

The calculation of the instantaneous cumulated time error preferably comprises integrating the frequency modulation signal FM(nT).

More specifically, the instantaneous cumulated time error can be calculated utilizing the following approximation:

$$\Delta Tcum(kTs) \sim \frac{Ndiv}{Fch} \cdot \sum_{k=1}^{\infty} \left( \frac{-FM(kTs)}{Fch} + \left( \frac{FM(kTs)}{Fch} \right)^2 \right) \cdot \frac{Fch}{N \cdot Fs}$$

In the above formula, *Ndiv* denotes the division factor between the frequency-modulated clock frequency and the frequency of its divided version, which is used by the sampling rate converter, *Fch* is the RF channel frequency (typically 2.4GHz), and *Fs* is the sampling frequency of the integrator. The corresponding number of cycles can be calculated as follows:

$$\Delta cycles(k) \sim \sum_{k=1}^{\infty} \left( \frac{-FM(k)}{Fch} + \left( \frac{FM(k)}{Fch} \right)^2 \right) \cdot \frac{Fch}{Ndiv \cdot Fs}$$

Figure 2 shows a circuit 201 according to a further exemplary embodiment, which is particularly applicable to a large-signal polar transmitter. The circuit 201 is similar to the circuit 101 shown in Figure 1 and discussed above, and this embodiment deviates only in the structure of the transmitter part of the circuit. Where Figure 1 shows a transmitter as a single unit 140 including the circuitry for performing amplitude modulation, the embodiment shown in Figure 2 comprises a transmitter 241 which is coupled to receive an amplitude modulated supply voltage Vddpa from an LDO (low-dropout regulator) 246. The control voltage to the LDO 246 is provided by a digital to analog converter (DAC) 244 and a reconstruction filter 245. The DAC receives the modified amplitude modulation signal AM_cor(nT) and is clocked through dividing unit 242 with a clock corresponding the frequency of LO(t) divided by M. Apart from this structure, the functions and principles described above in conjunction with Figure 1 apply equally to this embodiment also.

Figure 3 shows a circuit diagram of a non-uniform clock time error calculation (NUCTEC) unit 320 according to an exemplary embodiment. In particular, the NUCTEC 320 may be used in the embodiments shown in Figure 1 and Figure 2. The NUCTEC unit 320 comprises a squaring unit 321, a first multiplier 322, a subtractor 323, an adder 324, a delay 325, a second multiplier 326, and an optional rounding unit 327. The frequency modulation signal FM(nT) is squared by squaring unit 321, multiplied by the reciprocal value of the channel frequency Flo at the first multiplier 322 and supplied to the positive input of the subtractor 323. The frequency modulation signal FM(nT) is also supplied to the negative input of the subtractor 323 and the result of the subtraction is supplied to one input of adder 324. The other input of adder 324 receives the previous value from delay 325 and the result of the addition is supplied to both the second multiplier 326 and the delay 325. The multiplier 326 multiplies the received value by the reciprocal value of M times the reference frequency Fref of the PLL 114, 214 and outputs the delay as a number of cycles Delay_cycles(nT) and, optionally, after rounding in rounding unit 327, as a delay value Delay(nT). In other words, the NUCTEC unit 320 implements calculations corresponding to the formulas above. As can be seen, this implementation is a simple and division-free hardware implementation operating at low clock frequencies without problematic impact on performance. The two factors 1/Flo and 1/M*Fref applied by multiplicators 322 and 326 do not require real-time multiplications but may be calculated offline by an ALU or CPU and loaded into registers.

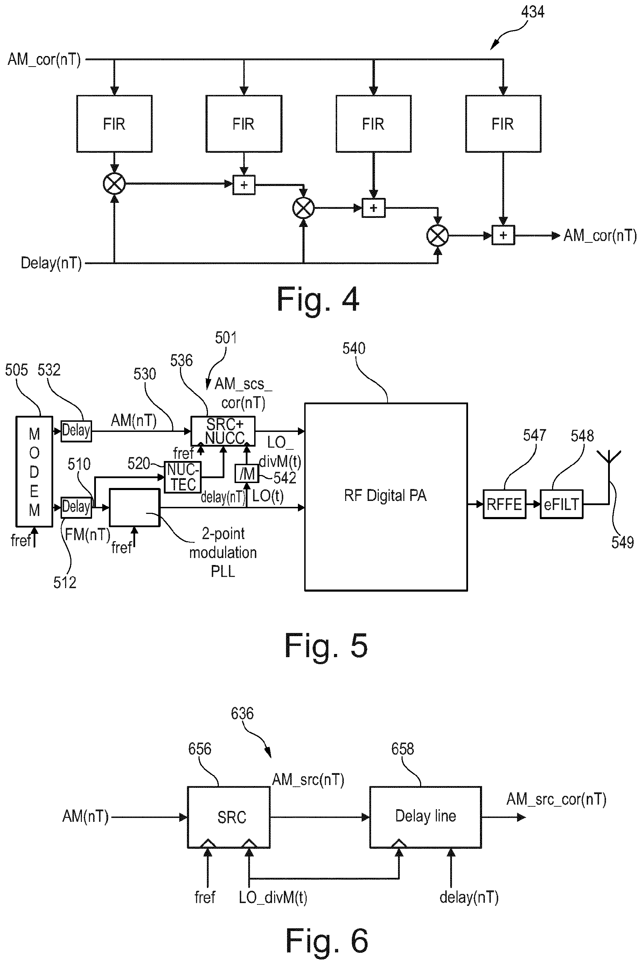

Figure 4 shows a circuit diagram of a non-uniform clock correction (NUCC) unit 434 according to an exemplary embodiment. More specifically, the NUCC unit 434 shown in Figure 4 is constituted by a fractional delay filter in the form of a Farrow structure comprising four finite impulse response filters FIR, three multipliers and three adders coupled as shown in the circuit diagram.

Figure 5 shows a circuit 501 according to a further exemplary embodiment. The circuit 501 differs from the circuits 101 and 201 shown respectively in Figure 1 and in Figure 2 and discussed above in that the NUCC units 134, 234 of said circuits are replaced by a combined SRC and NUCC unit 536 which applies both sample rate conversion (SRC) and non-uniform clock correction in line with the principles of the present disclosure. The circuit 501 is implemented in a polar transmitter comprising a digital power amplifier (PA) 540. Embodiments of the present disclosure may use any type of digital PA. The SRC+NUCC unit 536 upsamples the amplitude modulation signal AM(nT) and then applies the delay value delay(nT) from the NUCTEC unit 520 to generate an upsampled and modified amplitude modulation signal AM_src_cor(nT) which is supplied to the input of the digital power amplifier 540. The amplitude of the output signal from the digital PA 540 is controlled by the received signal AM_src_cor(nT). By upsampling the amplitude modulation signal, AM images or replicas are effectively attenuated.

Figure 6 shows a circuit diagram of a non-uniform clock correction unit 636 according to a further exemplary embodiment. More specifically, the NUCC unit 636 is an implementation of the combined SRC and NUCC unit 536 shown in Figure 5. The NUCC unit 636 comprises a sampling rate converter 656 and a delay line 658. The sampling rate converter 636 is configured to generate an upsampled amplitude modulation signal AM_src(nT) by converting AM(nT) from the low sampling rate fref (which is the reference clock frequency of the PLL circuit 114, 214) to a frequency divided version of the frequency modulated signal LO(t), namely LO_divM(t). The SRC 656 can e.g., be implemented as a Farrow SRC or as a modified Farrow SRC. However, any other fractional sample rate converter structure may also be used. The delay line 658 is configured to output a time-shifted version AM_src_Cor(nT) of the AM input signal, where the time-shift is time-variable and depends upon the delay value delay(nT) from the NUCTEC unit 520.

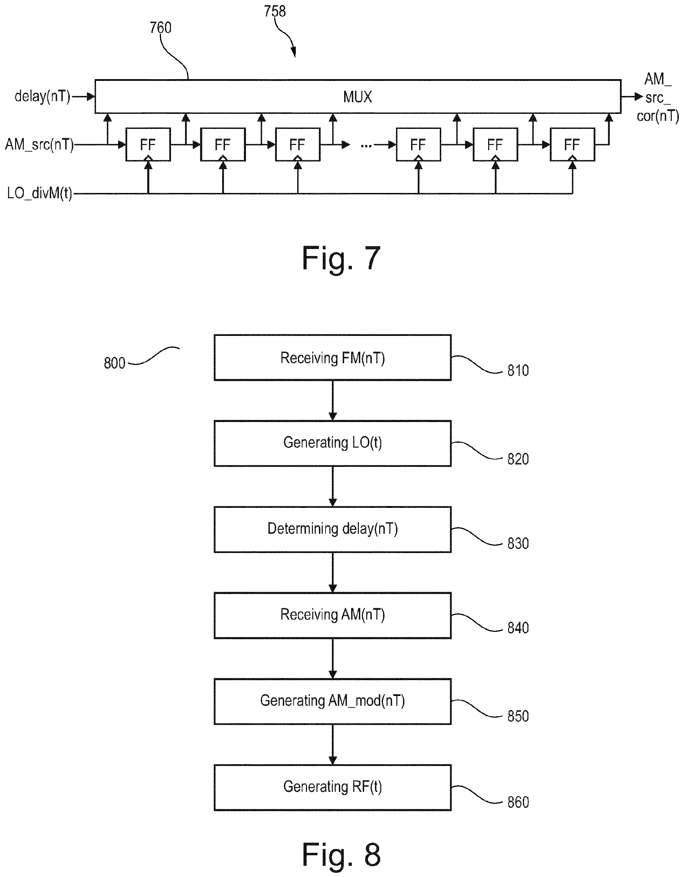

Figure 7 shows a circuit diagram of a delay line 758 according to an exemplary embodiment. In particular, Figure 7 shows an exemplary implementation of the delay line 658 shown in Figure 6 and discussed above. The input to the delay line 759 is the AM signal after SRC, i.e., AM src(nT). The delay value delay(nT) from the NUCTEC unit 114, 214 is provided to multiplexer circuit 760 which is connected to a line of flip flops FF as shown, the line of FFs forming the actual delay line. The clock non-uniformity is corrected according to the following principle:

- if no correction is required, the delay line output is connected to the middle tap of the delay line;
- if the FM signal is positive (Flo_div > Flo_div0), a past sample is picked up in the delay line to compensate for this too-fast clock;
- if the FM signal is negative (Flo_div < Flo_div0), a next sample is picked up in the delay line to compensate for this too-slow clock.

Figure 8 shows a flowchart 800 of a method according to an exemplary embodiment. The method 800 of operating a polar transmitter comprises a number of steps which, unless otherwise specified, may be performed in any order and not necessarily in the order of description. At 810, the method 800 comprises a step of receiving a frequency modulation signal FM(nT). At 820, the method 800 comprises a step of generating a frequency modulated signal LO(t) based on the frequency modulation signal FM(nT). At 830, the method 800 comprises a step of determining a delay value delay (nT) based on the frequency modulation signal FM(nT). At 840, the method 800 comprises a step of receiving an amplitude modulation signal AM(nT). At 850, the method 800 comprises a step fo generating a modified amplitude modulation signal AM_mod(nT) based on the amplitude modulation signal AM(nT) and the delay value delay(nT). At 860, the method 800 comprises a step of generating a modulated signal RF(t) based on the frequency modulated signal LO(t) and the modified amplitude modulation signal AM_mod(nT).

It is noted that, unless otherwise indicated, the use of terms such as "upper", "lower", "left", and "right" refers solely to the orientation of the corresponding drawing.

It is noted that the term "comprising" does not exclude other elements or steps and that the use of the articles "a" or "an" does not exclude a plurality. Also, elements described in association with different embodiments may be combined. It should also be noted that reference signs in the claims should not be construed as limiting the scope of the claims.

**Claims**

1. A circuit (101, 201, 501) for a polar transmitter, the circuit comprising:

a frequency modulation path (110, 210, 510) coupled to receive a frequency modulation signal (FM(nT)) and configured to generate a frequency modulated signal (LO(t)) based on the frequency modulation signal;

a non-uniform clock time error calculation unit (120, 220, 320, 520) configured to determine a delay value (delay(nT)) based on the frequency modulation signal;

an amplitude modulation path (130, 230, 530) coupled to receive an amplitude modulation signal (AM(nT)) and comprising a non-uniform clock correction unit (134, 234, 434, 536) coupled to the non-uniform clock time error calculation unit and configured to generate a modified amplitude modulation signal (AM_mod(nT), AM_src_mod(nT)) based on the amplitude modulation signal and the delay value; and

a transmitter (140, 241) coupled to the frequency modulation path and the amplitude modulation path, wherein the transmitter is configured to generate a modulated signal based on the frequency modulated signal and the modified amplitude modulation signal.

2. The circuit according to claim 1, wherein the transmitter is configured to derive a transmitter clock (LO_divM(t)) from the frequency modulated signal.

3. The circuit according to claim 1 or 2, wherein the transmitter is configured to derive the transmitter clock from the frequency modulated signal by dividing a frequency of the frequency modulated signal by a predetermined number M, in particular a predetermined integer number or a predetermined fractional number.

4. The circuit according to any one of claims 1 to 3, wherein the non-uniform clock time error calculation unit is configured to determine the delay value by calculating an instantaneous cumulated time error of the transmitter clock relative to a reference clock used to generate the frequency modulation signal and the amplitude modulation signal.

5. The circuit according to claim 4, wherein calculating the instantaneous cumulated time error comprises integrating the frequency modulation signal.

6. The circuit according to any one of claims 1 to 5, wherein the non-uniform clock correction unit comprises a fractional delay filter, in particular a fractional delay filter that is configured as a Farrow structure.

7. The circuit according to any one of claims 1 to 5, wherein the non-uniform clock correction unit comprises a sampling rate converter (656) configured to generate an up-sampled amplitude modulation signal (AM src(nT)), and wherein the non-uniform clock correction unit is configured to generate the modified amplitude modulation signal (AM-src_cor(NT)) based on the up-sampled amplitude modulation signal and the delay value.

8. The circuit according to claim 7, wherein the sampling rate converter is configured to apply a sampling rate which is based on the frequency of the frequency modulated signal, wherein the sampling rate converter in particular comprises a Farrow sampling rate converter or a modified Farrow sampling rate converter.

9. The circuit according to claim 7 or 8, wherein the transmitter comprises a digital RF power amplifier (540) configured to provide an output signal with an amplitude that depends on the modified amplitude modulation signal.

10. The circuit according to any one of claims 1 to 9, wherein the frequency modulation path comprises a 2-point modulation PLL circuit (114, 214, 514) configured to generate the frequency modulated signal.

11. A method (800) of operating a polar transmitter, the method comprising:

receiving (810) a frequency modulation signal (FM(nT));
generating (820) a frequency modulated signal (LO(t)) based on the frequency modulation signal;
determining (830) a delay value (delay(nT)) based on the frequency modulation signal;
receiving (840) an amplitude modulation signal (AM(nT));
generating (850) a modified amplitude modulation signal (AM_mod(nT)) based on the amplitude modulation signal and the delay value; and
generating (860) a modulated signal (RF(t)) based on the frequency modulated signal and the modified amplitude modulation signal.

12. The method according to claim 11, further comprising

deriving a transmitter clock from the frequency modulated signal, and

utilizing the transmitter clock to sample the modified amplitude modulation signal when generating the modulated signal.

13. The method according to claim 11 or 12, wherein determining the delay value comprises calculating an instantaneous cumulated time error of the transmitter clock relative to a reference clock used to generate the frequency modulation signal and the amplitude modulation signal, wherein calculating the instantaneous cumulated time error in particular comprises integrating the frequency modulation signal.

14. The method according to any one of claims 11 to 13, wherein generating the modified amplitude modulation signal utilizes a fractional delay filter, in particular a fractional delay filter that is configured as a Farrow structure.

15. The method according to any one of claims 11 to 14, further comprising:

generating an up-sampled amplitude modulation signal, in particular by utilizing a sample rate converter configured to apply a sampling rate which is based on the frequency of the frequency modulated signal, wherein the sampling rate converter in particular comprises a Farrow sampling rate converter or a modified Farrow sampling rate converter, and
generating the modified amplitude modulation signal based on the up-sampled amplitude modulation signal and the delay value.

**Amended claims in accordance with Rule 137(2) EPC.**

1. A circuit (101, 201, 501) for a polar transmitter, the circuit comprising:

a frequency modulation path (110, 210, 510) coupled to receive a frequency modulation signal (FM(nT)) and configured to generate a frequency modulated signal (LO(t)) based on the frequency modulation signal;
a non-uniform clock time error calculation unit (120, 220, 320, 520) configured to determine a delay value (delay(nT)) based on the frequency modulation signal;
an amplitude modulation path (130, 230, 530) coupled to receive an amplitude modulation signal (AM(nT)) and comprising a non-uniform clock correction unit (134, 234, 434, 536) coupled to the non-uniform clock time error calculation unit and configured to generate a modified amplitude modulation signal (AM_mod(nT), AM_src_mod(nT)) based on the amplitude modulation signal and the delay value; and
a transmitter (140, 241) coupled to the frequency modulation path and the amplitude modulation path, wherein the transmitter is configured to generate a modulated signal based on the frequency modulated signal and the modified amplitude modulation signal,
wherein the non-uniform clock time error calculation unit is configured to determine the delay value by calculating an instantaneous cumulated time error of a transmitter clock relative to a reference clock used to generate the frequency modulation signal and the amplitude modulation signal.

2. The circuit according to claim 1, wherein the transmitter is configured to derive the transmitter clock (LO_divM(t)) from the frequency modulated signal.

3. The circuit according to claim 1 or 2, wherein the transmitter is configured to derive the transmitter clock from the frequency modulated signal by dividing a frequency of the frequency modulated signal by a predetermined number M, in particular a predetermined integer number or a predetermined fractional number.

4. The circuit according to any one of claims 1 to 3, wherein calculating the instantaneous cumulated time error comprises integrating the frequency modulation signal.

5. The circuit according to any one of claims 1 to 4, wherein the non-uniform clock correction unit comprises a fractional delay filter, in particular a fractional delay filter that is configured as a Farrow structure.

6. The circuit according to any one of claims 1 to 4, wherein the non-uniform clock correction unit comprises a sampling rate converter (656) configured to generate an up-sampled amplitude modulation signal (AM_src(nT)), and wherein the non-uniform clock correction unit is configured to generate the modified amplitude modulation signal (AMsrc_cor(NT)) based on the up-sampled amplitude modulation signal and the delay value.

7. The circuit according to claim 6, wherein the sampling rate converter is configured to apply a sampling rate which is based on the frequency of the frequency modulated signal, wherein the sampling rate converter in particular comprises a Farrow sampling rate converter or a modified Farrow sampling rate converter.

8. The circuit according to claim 6 or 7, wherein the transmitter comprises a digital RF power amplifier (540) configured to provide an output signal with an amplitude that depends on the modified amplitude modulation signal.

9. The circuit according to any one of claims 1 to 8, wherein the frequency modulation path comprises a 2-point modulation PLL circuit (114, 214, 514) configured to generate the frequency modulated signal.

10. A method (800) of operating a polar transmitter, the method comprising:

   receiving (810) a frequency modulation signal (FM(nT));
   generating (820) a frequency modulated signal (LO(t)) based on the frequency modulation signal;
   determining (830) a delay value (delay(nT)) based on the frequency modulation signal;
   receiving (840) an amplitude modulation signal (AM(nT));
   generating (850) a modified amplitude modulation signal (AM_mod(nT)) based on the amplitude modulation signal and the delay value; and
   generating (860) a modulated signal (RF(t)) based on the frequency modulated signal and the modified amplitude modulation signal,
   wherein determining the delay value comprises calculating an instantaneous cumulated time error of a transmitter clock relative to a reference clock used to generate the frequency modulation signal and the amplitude modulation signal.

11. The method according to claim 10, further comprising

   deriving the transmitter clock from the frequency modulated signal, and
   utilizing the transmitter clock to sample the modified amplitude modulation signal when generating the modulated signal.

12. The method according to claim 10 or 11, wherein calculating the instantaneous cumulated time error comprises integrating the frequency modulation signal.

13. The method according to any one of claims 10 to 12, wherein generating the modified amplitude modulation signal utilizes a fractional delay filter, in particular a fractional delay filter that is configured as a Farrow structure.

14. The method according to any one of claims 10 to 13, further comprising:

   generating an up-sampled amplitude modulation signal, in particular by utilizing a sample rate converter configured to apply a sampling rate which is based on the frequency of the frequency modulated signal, wherein the sampling rate converter in particular comprises a Farrow sampling rate converter or a modified Farrow sampling rate converter, and
   generating the modified amplitude modulation signal based on the up-sampled amplitude modulation signal and the delay value.

Fig. 1

Fig. 2

Fig. 3

434

## Fig. 4

## Fig. 5

## Fig. 6

Fig. 7

Fig. 8

Europäisches
Patentamt

European
Patent Office

Office européen
des brevets

# EUROPEAN SEARCH REPORT

Application Number

EP 23 15 1958

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2020/212944 A1 (PREISSL CHRISTOPH [AT] ET AL) 2 July 2020 (2020-07-02) | 1-7,9-15 | INV. H03C3/09 |
| A | * figures 21, 27 * | 8 | H03C5/00 |
| | ----- | | |
| X | US 7 532 679 B2 (TEXAS INSTRUMENTS INC [US]) 12 May 2009 (2009-05-12) | 1-7,9, 11-15 | |
| A | * paragraph [0052]; figure 2 * | 8 | |
| | ----- | | |
| X | US 7 801 244 B2 (RF MICRO DEVICES INC [US]) 21 September 2010 (2010-09-21) | 1-6, 11-14 | |
| A | * paragraph [0042]; figure 7 * | 8 | |
| | ----- | | |

TECHNICAL FIELDS
SEARCHED      (IPC)

H03C

The present search report has been drawn up for all claims

| Place of search | Date of completion of the search | Examiner |
|---|---|---|
| Munich | 7 August 2023 | Schnabel, Florian |

CATEGORY OF CITED DOCUMENTS

X : particularly relevant if taken alone
Y : particularly relevant if combined with another
     document of the same category
A : technological background
O : non-written disclosure
P : intermediate document

T : theory or principle underlying the invention
E : earlier patent document, but published on, or
     after the filing date
D : document cited in the application
L : document cited for other reasons

& : member of the same patent family, corresponding
     document

EPO FORM 1503 03.82 (P04C01)

## ANNEX TO THE EUROPEAN SEARCH REPORT
## ON EUROPEAN PATENT APPLICATION NO.

EP 23 15 1958

This annex lists the patent family members relating to the patent documents cited in the above-mentioned European search report.
The members are as contained in the European Patent Office EDP file on
The European Patent Office is in no way liable for these particulars which are merely given for the purpose of information.

07-08-2023

| Patent document cited in search report | | Publication date | Patent family member(s) | | Publication date |
|---|---|---|---|---|---|
| US 2020212944 | A1 | 02-07-2020 | CN 113196651 A | | 30-07-2021 |
| | | | DE 112019006464 T5 | | 23-09-2021 |
| | | | US 2020212944 A1 | | 02-07-2020 |
| | | | WO 2020139435 A1 | | 02-07-2020 |
| US 7532679 | B2 | 12-05-2009 | NONE | | |
| US 7801244 | B2 | 21-09-2010 | NONE | | |

EPO FORM P0459

For more details about this annex : see Official Journal of the European Patent Office, No. 12/82